(19) Europäisches Patentamt
European Patent Office
Office européen des brevets

(11) **EP 4 131 362 A1**

(12) **EUROPEAN PATENT APPLICATION**
published in accordance with Art. 153(4) EPC

(43) Date of publication:
**08.02.2023 Bulletin 2023/06**

(21) Application number: **21778710.0**

(22) Date of filing: **31.03.2021**

(51) International Patent Classification (IPC):
**H01L 23/14** (1974.07)     **H05K 1/05** (1980.01)

(52) Cooperative Patent Classification (CPC):
**H01L 23/14; H05K 1/05;** H01L 2224/16225

(86) International application number:
**PCT/JP2021/013892**

(87) International publication number:
**WO 2021/201119 (07.10.2021 Gazette 2021/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2020   JP 2020065162**

(71) Applicant: **Mitsubishi Materials Corporation Tokyo 100-8117 (JP)**

(72) Inventors:
• **ISHIKAWA, Fumiaki**
  **Saitama-shi, Saitama 330-8508 (JP)**
• **HARA, Shintaro**
  **Saitama-shi, Saitama 330-8508 (JP)**

(74) Representative: **Hoffmann Eitle Patent- und Rechtsanwälte PartmbB Arabellastraße 30 81925 München (DE)**

(54) **METAL BASE SUBSTRATE**

(57)    A metal base substrate of the present invention includes a metal substrate, an insulating layer, and a circuit layer, which are laminated in this order, in which the insulating layer contains an insulating resin and an inorganic filler, and an elastic modulus (unit: GPa) at 100°C of the insulating layer, an elastic modulus (unit: GPa) at 100°C of the circuit layer, a thickness (unit: $\mu$m) of the insulating layer, a thickness (unit: $\mu$m) of the circuit layer, and a thickness (unit: $\mu$m) of the metal substrate are set so as to satisfy predetermined formulae.

FIG. 1

EP 4 131 362 A1

## Description

TECHNICAL FIELD

The present invention relates to a metal base substrate.

Priority is claimed on Japanese Patent Application No. 2020-065162, filed March 31, 2020, the content of which is incorporated herein by reference.

BACKGROUND ART

As one of the substrates for mounting electronic components such as semiconductor elements or LEDs, metal base substrates are known. A metal base substrate is a laminate in which a metal substrate, an insulating layer, and a circuit layer are laminated in this order. The insulating layer is generally formed of an insulating composition containing a resin having excellent insulating properties or withstand voltage and an inorganic filler having excellent thermal conductivity. An electronic component is mounted on the circuit layer via solder. In the metal base substrate configured as described above, heat generated from the electronic component is transferred to the metal substrate via the insulating layer and dissipated from the metal substrate to the outside.

In the metal base substrate, when the difference in thermal expansion coefficient between the metal base substrate and the electronic component bonded to the metal base substrate via solder is large, there are cases where stress that is applied to the solder bonding the electronic component and the metal base substrate increases due to the thermal cycles depending on the electronic component being turned on and off or external environments and solder cracks may be initiated. Therefore, it has been studied to alleviate the difference in thermal expansion coefficient between the metal substrate of the metal base substrate and the electronic component with the insulating layer by decreasing the elastic modulus of the insulating layer of the metal base substrate (Patent Documents 1 and 2).

[Citation List]

[Patent Documents]

[Patent Document 1]
Japanese Unexamined Patent Application, First Publication No.H11-87866
[Patent Document 2]
Japanese Unexamined Patent Application, First Publication No. 2016-111171

SUMMARY OF INVENTION

Technical Problem

For suppressing the initiation of solder cracks due to the thermal cycles at the time of mounting electronic components and improving reliability against the thermal cycles, it is effective to alleviate thermal stress caused by the expansion of the metal base substrate by decreasing the elastic modulus of the insulating layer of the metal base substrate to make the insulating layer easily deform. However, since stress caused by the expansion of the circuit layer is also present in the solder, there are limitations on improvement in the reliability against the thermal cycles only by decreasing the elastic modulus of the insulating layer of the metal base substrate.

The present invention has been made in view of the above-described circumstances, and an objective of the present invention is to provide a metal base substrate having excellent reliability against thermal cycles at the time of mounting an electronic component.

Solution to Problem

In order to solve the above-described problem, a metal base substrate according to one aspect of the present invention includes a metal substrate, an insulating layer, and a circuit layer, which are laminated in this order, in which the insulating layer contains an insulating resin and an inorganic filler, in a case where the metal substrate is a copper substrate having a thickness of less than 1600 $\mu$m, A that is defined by the following formula (1) is in a range of $0.50 \times 10^8$ or more and $3.10 \times 10^8$ or less, in a case where the metal substrate is a copper substrate having a thickness of 1600 $\mu$m or more, B that is defined by the following formula (II) is in a range of $0.50 \times 10^8$ or more and $3.10 \times 10^8$ or

less, in a case where the metal substrate is an aluminum substrate having a thickness of less than 1600 $\mu$m, C that is defined by the following formula (III) is in a range of $0.50 \times 10^8$ or more and $3.10 \times 10^8$ or less, and, in a case where the metal substrate is an aluminum substrate having a thickness of 1600 $\mu$m or more, D that is defined by the following formula (IV) is in a range of $0.50 \times 10^8$ or more and $3.10 \times 10^8$ or less.

$$A = \left\{ \left(0.56 \times t_3\right)^{0.9} + \left\{ \frac{0.001 \times k_2 \times t_2 \times \log\left(\frac{t_1}{k_1}\right)}{\log t_3} \right\} - 0.03 \times t_3 \times \left(\frac{t_1}{k_1}\right)^{0.12} \right\}$$

$$\times\, 921000 - 107800000 \qquad \cdots (\text{I})$$

$$B = \left\{ \left(896\right)^{0.9} + \left\{ \frac{0.001 \times k_2 \times t_2 \times \log\left(\frac{t_1}{k_1}\right)}{\log t_3} \right\} - 0.03 \times t_3 \times \left(\frac{t_1}{k_1}\right)^{0.12} \right\}$$

$$\times\, 921000 - 107800000 \qquad \cdots (\text{II})$$

$$C = \left\{ \left(0.99 \times t_3\right)^{0.9} + \left\{ \frac{0.0009 \times k_2 \times t_2 \times \log\left(\frac{t_1}{k_1}\right)}{\log t_3} \right\} - 0.026 \times t_3 \times \left(\frac{t_1}{k_1}\right)^{0.19} - 0.0019 \times (\log t_3) \times k_2 \times t_2 \right\}$$

$$\times\, 792980 - 174800000 \qquad \cdots (\text{III})$$

$$D = \left\{ \left(1584\right)^{0.9} + \left\{ \frac{0.0009 \times k_2 \times t_2 \times \log\left(\frac{t_1}{k_1}\right)}{\log t_3} \right\} - 0.026 \times t_3 \times \left(\frac{t_1}{k_1}\right)^{0.19} - 0.0019 \times (\log t_3) \times k_2 \times t_2 \right\}$$

$$\times\, 792980 - 174800000 \qquad \cdots (\text{IV})$$

In the formula (I) to the formula (IV), $k_1$ represents an elastic modulus (unit: GPa) at 100°C of the insulating layer, $k_2$ represents an elastic modulus (unit: GPa) at 100°C of the circuit layer, $t_1$ represents a thickness (unit: $\mu$m) of the insulating layer, $t_2$ represents a thickness (unit: $\mu$m) of the circuit layer, and $t_3$ represents a thickness (unit: $\mu$m) of the metal substrate.

According to the metal base substrate of the present invention, since each of the A to D values that are calculated by the formulae (I) to (IV) highly correlates with von Mises stress that is applied to solder during thermal cycles at the time of mounting an electronic component such as a semiconductor element or LED on the metal base substrate using the solder, and these A to D values are in a range of $0.50 \times 10^8$ or more and $3.10 \times 10^8$ or less, the von Mises stress that is applied to the solder, which is initiated when the thermal cycles is applied, becomes small. In addition, since it is not necessary to excessively decrease the elastic modulus of the insulating layer, the circuit layerbinding force of the insulating layer does not decrease. Therefore, the metal base substrate of the present invention is excellent in terms of reliability against thermal cycles at the time of mounting electronic components.

Here, in the metal base substrate of the present invention, it is preferable that the insulating layer has a ratio of the thickness (unit: $\mu$m) to the elastic modulus (unit: GPa) at 100°C of 10 or more.

In this case, since the thickness/elastic modulus of the insulating layer is as large as 10 or more, the insulating layer becomes easily deformable, and it becomes easy to alleviate the difference in thermal expansion coefficient between the metal substrate and the electronic component due to the thermal cycles with the insulating layer. Therefore, this metal base substrate further improves in reliability against thermal cycles at the time of mounting electronic components.

Advantageous Effects of Invention

According to the present invention, it is possible to provide a metal base substrate having excellent reliability against thermal cycles at the time of mounting electronic components.

BRIEF DESCRIPTION OF DRAWINGS

Fig. 1 is a schematic cross-sectional view of a metal base substrate according to an embodiment of the present invention.
Fig. 2 is a cross-sectional view schematically showing a bonded structure used for calculation of simulation values of von Mises stress.
Fig. 3 is a plan view of the bonded structure shown in Fig. 2.

DESCRIPTION OF EMBODIMENTS

Hereinafter, an embodiment of the present invention will be described with reference to the accompanying drawings.

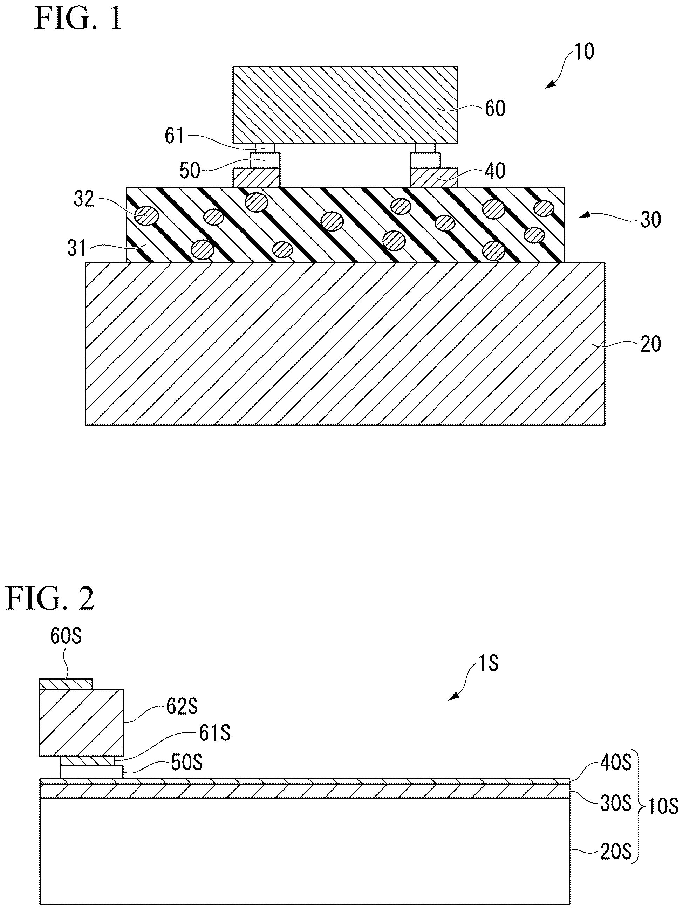

Fig. 1 is a schematic cross-sectional view of a metal base substrate according to the embodiment of the present invention.
In Fig. 1, a metal base substrate 10 is a laminate in which a metal substrate 20, an insulating layer 30, and circuit layers 40 are laminated in this order. Electrode terminals 61 of an electronic component 60 are connected onto the circuit layers 40 of the metal base substrate 10 via solder 50.
The metal substrate 20 is a member that serves as a base of the metal base substrate 10. The metal substrate 20 is a copper substrate or an aluminum substrate. The copper substrate is made of copper or a copper alloy. The aluminum substrate is made of aluminum or an aluminum alloy.
The insulating layer 30 is a layer for insulating the metal substrate 20 and the circuit layers 40. The insulating layer 30 is formed of an insulating resin composition containing an insulating resin 31 and an inorganic filler 32. When the insulating layer 30 is formed of the insulating resin composition containing the insulating resin 31 having high insulating properties and the inorganic filler 32 having a high thermal conductivity, it is possible to further reduce the thermal resistance of the entire metal base substrate 10 from the circuit layers 40 through the metal substrate 20 while maintaining the insulating properties.
The insulating resin 31 preferably contains a polyimide resin, a polyamide-imide resin, or a mixture thereof. Since these resins are excellent in terms of characteristics such as insulating properties, withstand voltage, chemical resistance, and mechanical characteristics, these characteristics of the metal base substrate 10 improve.
The inorganic filler 32 preferably has an average particle size in a range of 0.1 $\mu$m or more and 20 $\mu$m or less. When the average particle size of the inorganic filler 32 is 0.1 $\mu$m or more, the thermal conductivity of the insulating layer 30 improves. When the average particle size of the inorganic filler 32 is 20 $\mu$m or less, the withstand voltage of the insulating layer 30 improves. In addition, when the average particle size of the inorganic filler 32 is in the above-described range, it is difficult for the inorganic filler 32 to form agglomerated particles, and it becomes easy to uniformly disperse the inorganic filler 32 in the insulating resin 31. When the inorganic filler 32 does not form any agglomerated particles and is dispersed in the insulating resin 31 as primary particles or fine particles that are nearly primary particles, the withstand voltage of the insulating layer 30 improves. From the viewpoint of improving the thermal conductivity of the insulating layer 30, the average particle size of the inorganic filler 32 is preferably in a range of 0.3 $\mu$m or more and 20 $\mu$m or less.
The content of the inorganic filler 32 in the insulating layer 30 is preferably in a range of 50% by volume or more and 85% by volume or less. When the content of the inorganic filler 32 is 50% by volume or more, the thermal conductivity of the insulating layer 30 improves. On the other hand, when the content of the inorganic filler 32 is 85% by volume or less, the withstand voltage of the insulating layer 30 improves. In addition, when the content of the inorganic filler 32 is in the above-described range, it becomes easy for the inorganic filler 32 to be uniformly dispersed in the insulating resin 31. When the inorganic filler 32 is uniformly dispersed in the insulating resin 31, the mechanical strength of the insulating layer 30 improves. From the viewpoint of improving the thermal conductivity of the insulating layer 30, the content of the inorganic filler 32 is particularly preferably in a range of 50% by volume or more and 80% by volume or less.

As the inorganic filler 32, alumina ($Al_2O_3$) particles, alumina hydrate particles, aluminum nitride (AlN) particles, silica ($SiO_2$) particles, silicon carbide (SiC) particles, titanium oxide ($TiO_2$) particles, boron nitride (BN) particles, and the like can be used. Among these fillers, alumina particles are preferable. The alumina particles are more preferably α-alumina particles. The α-alumina particles preferably have a ratio of the tapped density to the true density (tapped density/true density) of 0.1 or more. The tapped density/true density correlates with the packing density of the α-alumina particles in the insulating layer 30, and, when the tapped density/true density is high, the packing density of the α-alumina particles in the insulating layer 30 can be increased. When the packing density of the α-alumina particles in the insulating layer 30 becomes high, the intervals between the α-alumina particles in the insulating layer 30 become narrow, and voids (pores) are less likely to be generated in the insulating layer 30. The tapped density/true density is preferably in a range of 0.2 or more and 0.9 or less. In addition, the α-alumina may be polycrystalline particles, but is particularly preferably single crystal particles.

The insulating layer 30 preferably has a ratio (thickness/elastic modulus) of the thickness (unit: μm) to the elastic modulus (unit: GPa) at 100°C of 10 or more. The thickness/elastic modulus of the insulating layer 30 is preferably in a range of 10 or more and 200000 or less, more preferably in a range of 20 or more and 20000 or less, and more preferably in a range of 50 or more and 200 or less. The elastic modulus at 100°C of the insulating layer 30 is preferably in a range of 0.001 GPa or more and 1 GPa or less. In addition, the thickness of the insulating layer 30 is preferably in a range of 10 μm or more and 200 μm or less.

The circuit layers 40 are formed in a circuit pattern. The electrode terminals 61 of the electronic component 60 are bonded onto the circuit layers 40 formed in the circuit pattern via the solder 50 or the like. As a material of the circuit layer 40, a metal such as copper, aluminum, or gold can be used. The circuit layer 40 is preferably made of a copper foil. The circuit layer 40 preferably has an elastic modulus in a range of 30 GPa or more and 200 GPa or less. In addition, the circuit layer 40 preferably has a thickness in a range of 2 μm or more and 200 μm or less.

In the metal base substrate 10 of the present embodiment, the relationships of the following formulae (I) to (IV) are established depending on the thickness range and material of the metal substrate. Specifically, in a case where the metal substrate 20 is a copper substrate and has a thickness of less than 1600 μm, A that is defined by the following formula (I) is set to be in a range of $0.50 \times 10^8$ or more and $3.10 \times 10^8$ or less. In addition, in a case where the metal substrate 20 is a copper substrate and has a thickness of 1600 μm or more, B that is defined by the following formula (II) is set to be in a range of $0.50 \times 10^8$ or more and $3.10 \times 10^8$ or less. In addition, in a case where the metal substrate 20 is an aluminum substrate and has a thickness of less than 1600 μm, C that is defined by the following formula (III) is set to be in a range of $0.50 \times 10^8$ or more and $3.10 \times 10^8$ or less. In addition, in a case where the metal substrate 20 is an aluminum substrate and has a thickness of 1600 μm or more, D that is defined by the following formula (IV) is set to be in a range of $0.50 \times 10^8$ or more and $3.10 \times 10^8$ or less.

$$A =$$

$$\left\{ (0.56 \times t_3)^{0.9} + \left\{ \frac{0.001 \times k_2 \times t_2 \times \log\left(\frac{t_1}{k_1}\right)}{\log t_3} \right\} - 0.03 \times t_3 \times \left(\frac{t_1}{k_1}\right)^{0.12} \right\}$$

$$\times\, 921000 - 107800000$$

$$\cdots\ (\,\mathrm{I}\,)$$

$$B =$$

$$\left\{ (896)^{0.9} + \left\{ \frac{0.001 \times k_2 \times t_2 \times \log\left(\frac{t_1}{k_1}\right)}{\log t_3} \right\} - 0.03 \times t_3 \times \left(\frac{t_1}{k_1}\right)^{0.12} \right\}$$

$$\times\, 921000 - 107800000$$

$$\cdots\ (\,\mathrm{I\,I}\,)$$

$$C =$$

$$\left\{ \left\{ (0.99 \times t_3)^{0.9} + \left\{ \frac{0.0009 \times k_2 \times t_2 \times \log\left(\frac{t_1}{k_1}\right)}{\log t_3} \right\} - 0.026 \times t_3 \times \left(\frac{t_1}{k_1}\right)^{0.19} - 0.0019 \times (\log t_3) \times k_2 \times t_2 \right\} \right.$$

$$\times\; 792980 - 174800000$$

$$\cdots\; (\,I\,I\,I\,)$$

$$D =$$

$$\left\{ \left\{ (1584)^{0.9} + \left\{ \frac{0.0009 \times k_2 \times t_2 \times \log\left(\frac{t_1}{k_1}\right)}{\log t_3} \right\} - 0.026 \times t_3 \times \left(\frac{t_1}{k_1}\right)^{0.19} - 0.0019 \times (\log t_3) \times k_2 \times t_2 \right\} \right.$$

$$\times\; 792980 - 174800000$$

$$\cdots\; (\,I\,V\,)$$

Here, in the formula (1) to the formula (IV), $k_1$ represents the elastic modulus (unit: GPa) at 100°C of the insulating layer, $k_2$ represents the elastic modulus (unit: GPa) at 100°C of the circuit layer, $t_1$ represents the thickness (unit: $\mu$m) of the insulating layer, $t_2$ represents the thickness (unit: $\mu$m) of the circuit layer, and $t_3$ represents the thickness (unit: $\mu$m) of the metal substrate.

The A to D values that are calculated by the formulae (I) to (IV) highly correlate with von Mises stress that is applied to the solder 50 during thermal cycles at the time of mounting the electronic component 60 on the metal base substrate 10 using the solder 50. Since the metal base substrate 10 has the A to D values set in a range of $0.50 \times 10^8$ or more and $3.10 \times 10^8$ or less, the von Mises stress that is applied to the solder 50 during the thermal cycles is normally suppressed in a range of $0.50 \times 10^8$ Pa or more and $3.10 \times 10^8$ Pa or less. Therefore, when thermal cycles is applied, cracks are less likely to be initiated in the solder 50. In addition, since it is not necessary to excessively decrease the elastic modulus of the insulating layer 30, the circuit layer 40-binding force of the insulating layer 30 is less likely to decrease. Therefore, it is possible to suppress stress that is applied to the solder 50 from the circuit layers 40.

The thicknesses of the metal substrate 20, the insulating layer 30, and the circuit layer 40 of the metal base substrate 10 can be measured, for example, in the following manner. The metal base substrate 10 is embedded in a resin, and a cross section is exposed by mechanical polishing. Next, the exposed cross section of the metal base substrate 10 is observed using an optical microscope, and the thicknesses of the metal substrate 20, the insulating layer 30, and the circuit layer 40 are measured.

The elastic modulus (tensile elastic modulus) of the metal substrate 20 of the metal base substrate 10 is measured by a tensile test (JIS Z 2241: 2011 Metallic materials - Tensile testing - Method of test at room temperature). The elastic modulus of the circuit layer 40 is measured by a resonance method (device: TE-RT manufactured by Nihon Techno-Plus Co., Ltd.or the like). The elastic modulus of the insulating layer 30 of the metal base substrate 10 can be measured, for example, in the following manner. The metal substrate 20 and the circuit layers 40 of the metal base substrate 10 are removed by etching, and the insulating layer 30 is isolated. The elastic modulus (tensile elastic modulus) of the obtained insulating layer 30 is measured by dynamic viscoelasticity measurement (DMA).

Examples of the electronic component 60 that is mounted on the metal base substrate 10 of the present embodiment are not particularly limited and include a semiconductor element, a resistor, a capacitor, a crystal oscillator, and the like. Examples of the semiconductor element include MOSFET (metal-oxide-semiconductor field effect transistor), IGBT (insulated gate bipolar transistor), LSI (large scale integration), LED (light emitting diode), an LED chip, and LED-CSP (LED-chip size package).

Hereinafter, a method for manufacturing the metal base substrate 10 of the present embodiment will be described.

The metal base substrate 10 according to the present embodiment can be manufactured by, for example, a method including a design step, an insulating layer forming step, and a circuit layer pressure-bonding step.

In the design step, the material and thickness of the metal substrate 20, the material and thickness of the insulating layer 30, and the material and thickness of the circuit layer 40 are set.

At first, the material and thickness of the metal substrate 20, the material and thickness of the insulating layer 30, and the material and thickness of the circuit layer 40 are temporarily set. The material and thickness of the metal substrate 20 are temporarily set based on, for example, heat radiation, sizes, or the like required for the metal base substrate 10. The material and thickness of the insulating layer 30 are temporarily set based on, for example, insulating properties and withstand voltage required for the metal base substrate 10. The material and thickness of the circuit layer 40 are temporarily set based on, for example, the electrical characteristics of the electronic component 60 that is mounted on the metal base substrate 10.

Next, the thickness of the material of the metal substrate 20, the elastic modulus at 100°C and thickness of the material of the insulating layer 30, and the elastic modulus at 100°C and thickness of the material of the circuit layer 40, which have been temporarily set, are assigned to any of the formulae (I) to (IV) to calculate A to D. In a case where the obtained A to D values are less than $1 \times 10^8$ or more than $3.10 \times 10^8$, the material and thickness of the metal substrate 20, the material and thickness of the insulating layer 30, and the material and thickness of the circuit layer 40 are temporarily set again. In a case where the A to D values are in the range of $1 \times 10^8$ or more and $3.10 \times 10^8$ or less, the metal base substrate 10 is manufactured with the material and thickness of the metal substrate 20, the material and thickness of the insulating layer 30, and the material and thickness of the circuit layer 40, which have been temporarily set.

In the insulating layer forming step, the insulating layer 30 is formed on the metal substrate 20 to obtain a metal substrate with an insulating layer. As a method for forming the insulating layer 30, a coating method or an electrodeposition method can be used.

The coating method is a method in which a coating liquid containing a solvent, an insulating resin, and an inorganic filler is applied onto the metal substrate 20 to form a coating layer, and then the coating layer is heated to obtain the insulating layer 30. As the coating liquid, an inorganic filler-dispersed resin material solution containing a resin material solution in which an insulating resin is dissolved and an inorganic filler dispersed in the resin material solution can be used. As a method for applying the coating liquid to the surface of the substrate, a spin coating method, a bar coating method, a knife coating method, a roll coating method, a blade coating method, a die coating method, a gravure coating method, a dip coating method, or the like can be used.

The electrodeposition method is a method in which the metal substrate 20 is immersed in an electrodeposition dispersion containing insulating resin particles and an inorganic filler, the insulating resin particles and the inorganic filler are electrodeposited on the surface of the substrate to form an electrodeposited film, and then the obtained electrodeposited film is heated to form the insulating layer 30. As the electrodeposition dispersion, an electrodeposition dispersion prepared by adding a poor solvent of an insulating resin material to an inorganic filler-dispersed insulating resin solution containing an insulating resin solution and an inorganic filler dispersed in the insulating resin solution and precipitating the insulating resin as particles can be used.

In the circuit layer pressure-bonding step, a metal foil is laminated on the insulating layer 30 of the metal substrate with the insulating layer, and the obtained laminate is heated and pressurized to form the circuit layers 40, thereby obtaining the metal base substrate 10. The heating temperature of the laminate is, for example, 200°C or higher and more preferably 250°C or higher. The upper limit of the heating temperature is lower than the thermal decomposition temperature of the insulating resin and preferably equal to or lower than a temperature that is lower than the thermal decomposition temperature by 30°C. The pressure that is applied during the pressure-bonding is, for example, in a range of 1 MPa or more and 30 MPa or less and more preferably in a range of 3 MPa or more and 25 MPa or less. The pressure-bonding time varies depending on the heating temperature or the pressure, but is generally 60 minutes or longer and 180 minutes or shorter.

In the metal base substrate 10 of the present embodiment configured as described above, each of the A to D values that are calculated by the formulae (I) to (IV) highly correlates with von Mises stress that is applied to the solder 50 during thermal cycles at the time of mounting the electronic component 60 on the metal base substrate 10 using the solder 50. In addition, according to the metal base substrate 10 of the present embodiment, since the A to D values are in a range of $0.50 \times 10^8$ or more and $3.10 \times 10^8$ or less, the von Mises stress in the solder 50 that is applied when the thermal cycles are applied becomes small. In addition, since it is not necessary to excessively decrease the elastic modulus of the insulating layer 30, the circuit layer 40-binding force of the insulating layer 30 does not decrease. Therefore, according to the metal base substrate 10 of the present embodiment, the reliability against thermal cycles at the time of mounting the electronic component 60 is excellent.

In addition, in the metal base substrate 10 of the present embodiment, when the ratio of the thickness (unit: $\mu$m) to the elastic modulus (unit: GPa) at 100°C of the insulating layer 30 is 10 or more, the insulating layer 30 becomes easily deformable, and it becomes easy to alleviate the difference in thermal expansion coefficient between the metal substrate 20 and the electronic component 60 due to the thermal cycles with the insulating layer 30. Therefore, the reliability of the metal base substrate 10 against the thermal cycles at the time of mounting the electronic component 60 further improves.

Hitherto, the embodiment of the present invention has been described, but the present invention is not limited thereto and can be appropriately modified within the scope of the technical concept of the invention.

EXAMPLES

[Present Invention Example 1]

A polyimide solution and an $\alpha$-alumina powder (crystal structure: single crystal, average particle size: 0.7 $\mu$m) were mixed such that the content rate of a polyimide and the $\alpha$-alumina powder in a solid matter (insulating layer) that was generated by heating became 60% by volume. A solvent was added to the obtained mixture to dilute the mixture such that the concentration of the polyimide became 5% by mass. Subsequently, the obtained diluted mixture was dispersed by repeating a high-pressure injection treatment at a pressure of 50 MPa 10 times using Star Burst manufactured by Sugino Machine Limited to prepare a coating liquid for forming an insulating layer.

A copper substrate (composition: C1100, tough pitch copper) that was 1000 $\mu$m in thickness, 30 mm in length, and 20 mm in width was prepared. The coating liquid for forming an insulating layer was applied to the surface of this copper substrate by a bar coating method to form a coating layer. Next, the copper substrate on which the coating layer was formed was disposed on a hot plate, the temperature was raised from room temperature up to 60°C at 3 °C/min, the copper substrate was heated at 60°C for 100 minutes, then, the temperature was further raised up to 120°C at 1 °C/min, and the copper substrate was heated at 120°C for 100 minutes to dry the coating layer. Next, the copper substrate was heated at 250°C for 1 minute and then heated at 400°C for 1 minute. A 30 $\mu$m-thick copper substrate with an insulating layer having the insulating layer made of the polyimide resin in which $\alpha$-alumina single crystal particles were dispersed and formed on the surface of the copper substrate was produced in the above-described manner.

A copper foil having a thickness of 140 $\mu$m (elastic modulus at 100°C: 75 GPa) was overlaid and laminated on the insulating layer of the obtained copper substrate with an insulating layer. Next, the obtained laminate was heated in vacuum at a pressure-bonding temperature of 300°C for 120 minutes under application of a pressure of 5 MPa using a carbon jig to pressure-bond the insulating layer and the copper foil. A copper base substrate in which the copper substrate, the insulating layer, and the copper foil were laminated in this order was produced in the above-described manner.

The thickness of the insulating layer in the obtained copper base substrate and the elastic modulus at 100°C of the insulating layer were measured as described below. The results are shown in Table 1.

(Thickness of insulating layer)

The copper base substrate was embedded in a resin, and a cross section was exposed by mechanical polishing. Next, the exposed cross section of the metal base substrate was observed using an optical microscope, and the thickness of the insulating layer was measured.

(Elastic modulus at 100°C of insulating layer)

The copper substrate and the copper foil of the copper base substrate were removed by etching, and an insulating film was isolated. The elastic modulus at 100°C of the obtained insulating film was measured by a tensile formula using a dynamic viscoelasticity measuring instrument (solid viscoelasticity analyzer RSA-G2 (manufactured by TA Instruments Japan Inc.)). As measurement conditions, the frequency was set to 1 Hz, and the temperature rise rate was set to 1 °C/min.

[Present Invention Examples 15, 16, 22, and 27]

Metal base substrates were produced in the same manner as in Present Invention Example 1 except that the thickness of the copper substrate, the thickness and elastic modulus at 100°C of the insulating layer, and the thickness and elastic modulus at 100°C of the circuit layer were each changed to values shown in Table 1 and Table 2 below. The elastic modulus of the insulating layer was adjusted by changing the amount of a filler packed and the type of a resin that was used as a matrix.

[Evaluation]

(Calculation of A value or B value)

For metal base substrates of Present Invention Examples 1 to 23 in which the thickness of the copper substrate was less than 1600 $\mu$m and the thickness and elastic modulus at 100°C of the insulating layer, and the thickness and elastic modulus at 100°C of the circuit layer were each the value shown in Table 1 below, A values were calculated using the formula (I). The results are shown in Table 1. In addition, for metal base substrates of Present Invention Examples 24 to 43 in which the thickness of the copper substrate was 1600 $\mu$m or more and the thickness and elastic modulus at 100°C of the insulating layer, and the thickness and elastic modulus at 100°C of the circuit layer were each the value shown in Table 2 below, B values were calculated using the formula (II). The results are shown in Table 2.

(Simulation value of von Mises stress)

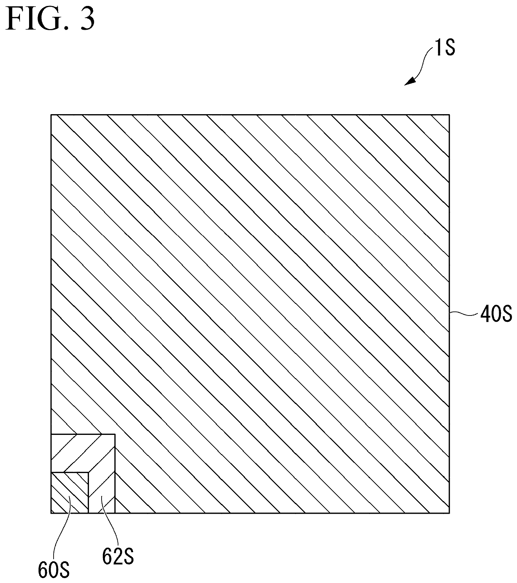

Simulation values of von Mises stress that was applied to solder when electronic components were mounted via the solder on metal base substrates for which the copper substrates, the insulating layers, and the copper foils used in Present Invention Examples 1 to 43 were used were calculated. Fig. 2 and Fig. 3 show schematic views of a bonded structure used for the calculation of the simulation values of von Mises stress. Fig. 2 is a cross-sectional view of the bonded structure, and Fig. 3 is a plan view of the bonded structure shown in Fig. 2. As shown in Fig. 2 and Fig. 3, a bonded structure 1S includes a metal base substrate 10S and an electronic component 60S bonded to a corner part of the metal base substrate 10S. The metal base substrate 10S is a laminate in which a metal substrate 20S, an insulating layer 30S, and a copper foil 40S are laminated in this order. The copper foil 40S is formed on the entire insulating layer 30S. The electronic component 60S includes an AIN (aluminum nitride) member 62S and a terminal S61. The electronic component 60S was an LED chip. The electronic component 60S and the copper foil 40S of the metal base substrate 10S are connected to each other via solder 50S. A simulation value of von Mises stress that was applied to the solder 50S of the bonded structure 1S was calculated. The simulation value of the von Mises stress was calculated using LISA (Sonnenhof Holdings). The characteristics of each member of the bonded structure 1S are as described below. The results are shown in Table 1 and Table 2.

(1) Metal substrate 20S

Thermal expansion coefficient: $1.8 \times 10^{-5}$ (copper), $2.4 \times 10^{-5}$ (aluminum)
Elastic modulus: 117 GPa (copper), 72 GPa (aluminum)
Poisson's ratio: 0.343 (copper), 0.343 (aluminum) (2) insulating layer 30S
Thermal expansion coefficient: $1.0 \times 10^{-5}$, Poisson's ratio: 0.343 (3) copper foil 40S
Thermal expansion coefficient: $1.8 \times 10^{-5}$, Poisson's ratio: 0.343 (4) solder 50S
Thermal expansion coefficient: $2.0 \times 10^{-5}$, Poisson's ratio: 0.38, Elastic modulus: 30 GPa (5) AIN (aluminum nitride) member 62S
Thermal expansion coefficient: $0.3 \times 10^{-5}$, Poisson's ratio: 0.3, Elastic modulus: 170 GPa (6) member to be bonded 70S (LED chip)
Thermal expansion coefficient: $0.7 \times 10^{-5}$, Poisson's ratio: 0.25, Elastic modulus: 470 GPa

[Table 1]

| | Metal substrate (copper substrate) | | Insulating layer | | | Circuit layer | | A value | Von Mises stress simulation value (Pa) |
|---|---|---|---|---|---|---|---|---|---|
| | Thickness (μm) | Elastic modulus at 100°C (GPa) | Thickness (μm) | Elastic modulus at 100°C (GPa) | Thickness/Elastic modulus (μm/Gpa) | Thickness (μm) | Elastic modulus at 100°C (GPa) | | |
| Present Invention Example 1 | 1000 | | 30 | 0.27 | 110 | 140 | 75 | 1.24E + 08 | 1.27E + 08 |
| Present Invention Example 2 | 1000 | | 30 | 0.27 | 110 | 140 | 100 | 1.26E + 08 | 1.29E + 08 |
| Present Invention Example 3 | 1000 | | 30 | 0.27 | 110 | 140 | 125 | 1.29E + 08 | 1.31E + 08 |
| Present Invention Example 4 | 1000 | | 110 | 2.0 | 55 | 140 | 75 | 1.27E + 08 | 1.31E + 08 |
| Present Invention Example 5 | 1000 | | 110 | 2.0 | 55 | 140 | 125 | 1.31E + 08 | 1.34E + 08 |
| Present Invention Example 6 | 1000 | | 110 | 4.0 | 28 | 140 | 75 | 1.30E + 08 | 1.32E + 08 |
| Present Invention Example 7 | 1000 | | 110 | 4.0 | 28 | 140 | 125 | 1.33E + 08 | 1.35E + 08 |

| | Metal substrate (copper substrate) | | Insulating layer | | | Circuit layer | | A value | Von Mises stress simulation value (Pa) |
|---|---|---|---|---|---|---|---|---|---|
| | Thickness ($\mu$m) | Elastic modulus at 100°C (GPa) | Thickness ($\mu$m) | Elastic modulus at 100°C (GPa) | Thickness/Elastic modulus ($\mu$m/Gpa) | Thickness ($\mu$m) | Elastic modulus at 100°C (GPa) | | |
| Present Invention Example 8 | 1000 | 125 | 110 | 8.0 | 14 | 140 | 75 | 1.32E + 08 | 1.31E + 08 |
| Present Invention Example 9 | 1000 | | 110 | 8.0 | 14 | 140 | 125 | 1.34E + 08 | 1.35E + 08 |
| Present Invention Example 10 | 1400 | | 30 | 0.27 | 110 | 140 | 75 | 2.01E + 08 | 1.98E + 08 |
| Present Invention Example 11 | 1400 | | 30 | 0.27 | 110 | 140 | 125 | 2.05E + 08 | 1.96E + 08 |
| Present Invention Example 12 | 1400 | | 110 | 8.0 | 14 | 140 | 75 | 2.14E + 08 | 2.27E + 08 |
| Present Invention Example 13 | 1400 | | 110 | 8.0 | 14 | 140 | 125 | 2.16E + 08 | 2.20E + 08 |
| Present Invention Example 14 | 1000 | | 30 | 0.27 | 110 | 35 | 75 | 1.19E + 08 | 1.11E + 08 |

| | Metal substrate (copper substrate) | | Insulating layer | | | Circuit layer | | A value | Von Mises stress simulation value (Pa) |
|---|---|---|---|---|---|---|---|---|---|
| | Thickness (μm) | Elastic modulus at 100°C (GPa) | Thickness (μm) | Elastic modulus at 100°C (GPa) | Thickness/Elastic modulus (μm/Gpa) | Thickness (μm) | Elastic modulus at 100°C (GPa) | | |
| Present Invention Example 15 | 1000 | | 30 | 0.27 | 110 | 35 | 100 | 1.20E + 08 | 1.19E + 08 |
| Present Invention Example 16 | 1000 | | 30 | 0.27 | 110 | 35 | 125 | 1.20E + 08 | 1.30E + 08 |
| Present Invention Example 17 | 1000 | | 110 | 2.0 | 55 | 35 | 75 | 1.23E + 08 | 1.19E + 08 |
| Present Invention Example 18 | 1000 | | 110 | 2.0 | 55 | 35 | 125 | 1.24E + 08 | 1.25E + 08 |
| Present Invention Example 19 | 1000 | | 110 | 4.0 | 28 | 35 | 75 | 1.26E + 08 | 1.24E + 08 |
| Present Invention Example 20 | 1000 | | 110 | 4.0 | 28 | 35 | 125 | 1.27E + 08 | 1.28L + 08 |
| Present Invention Example 21 | 1000 | | 110 | 8.0 | 14 | 35 | 75 | 1.29E + 08 | 1.26E + 08 |

EP 4 131 362 A1

| | Metal substrate (copper substrate) | | Insulating layer | | | Circuit layer | | A value | Von Mises stress simulation value (Pa) |
|---|---|---|---|---|---|---|---|---|---|
| | Thickness (μm) | Elastic modulus at 100°C (GPa) | Thickness (μm) | Elastic modulus at 100°C (GPa) | Thickness/Elastic modulus (μm/Gpa) | Thickness (μm) | Elastic modulus at 100°C (GPa) | | |
| Present Invention Example 22 | 1000 | | 110 | 8.0 | 14 | 35 | 125 | 1.30E + 08 | 1.29E + 08 |
| Present Invention Example 23 | 1400 | | 30 | 0.27 | 110 | 35 | 75 | 1.97E + 08 | 2.08E + 08 |

[Table 2]

| | Metal substrate (copper substrate) | | Insulating layer | | | Circuit layer | | B value | Von Mises stress simulation value (Pa) |
|---|---|---|---|---|---|---|---|---|---|
| | Thickness (μm) | Elastic modulus at 100°C (GPa) | Thickness (μm) | Elastic modulus at 100°C (GPa) | Thickness/Elastic modulus (μm/Gpa) | Thickness (μm) | Elastic modulus at 100°C (GPa) | | |
| Present Invention Example 24 | 1600 | | 30 | 0.27 | 110 | 140 | 75 | 2.39E + 08 | 2.10E + 08 |
| Present Invention Example 25 | 1600 | | 110 | 8.0 | 14 | 140 | 75 | 2.53E + 08 | 2.45E + 08 |
| Present Invention Example 26 | 1600 | | 110 | 8.0 | 14 | 140 | 125 | 2.56E + 08 | 2.37E + 08 |
| Present Invention Example 27 | 1800 | | 110 | 8.0 | 14 | 140 | 125 | 2.48E + 08 | 2.39E + 08 |
| Present Invention Example 28 | 2000 | | 30 | 0.27 | 110 | 140 | 75 | 2.19E + 08 | 2.05E + 08 |
| Present Invention Example 29 | 2000 | | 30 | 0.27 | 110 | 140 | 100 | 2.21E + 08 | 2.04E + 08 |
| Present Invention Example 30 | 2000 | | 30 | 0.27 | 110 | 140 | 125 | 3.23L + 08 | 2.02H + 08 |

| | Metal substrate (copper substrate) | | Insulating layer | | | Circuit layer | | B value | Von Mises stress simulation value (Pa) |
|---|---|---|---|---|---|---|---|---|---|
| | Thickness (μm) | Elastic modulus at 100°C (GPa) | Thickness (μm) | Elastic modulus at 100°C (GPa) | Thickness/Elastic modulus (μm/Gpa) | Thickness (μm) | Elastic modulus at 100°C (GPa) | | |
| Present Invention Example 31 | 2000 | 125 | 110 | 8.0 | 14 | 140 | 75 | 2.38E + 08 | 2.41E + 08 |
| Present Invention Example 32 | 2000 | | 110 | 8.0 | 14 | 140 | 100 | 2.39E + 08 | 2.38E + 08 |
| Present Invention Example 33 | 2000 | | 110 | 8.0 | 14 | 140 | 125 | 2.40E + 08 | 2.35E + 08 |
| Present Invention Example 34 | 1600 | | 30 | 0.27 | 110 | 35 | 75 | 2.34E + 08 | 2.24E + 08 |
| Present Invention Example 35 | 1600 | | 30 | 0.27 | 110 | 35 | 125 | 2.35E + 08 | 2.68E + 08 |
| Present Invention Example 36 | 1600 | | 110 | 8.0 | 14 | 35 | 75 | 2.51E + 08 | 2.47E + 08 |
| Present Invention Example 37 | 1600 | | 110 | 8.0 | 14 | 35 | 125 | 2.51E + 08 | 2.45E + 08 |

EP 4 131 362 A1

| | Metal substrate (copper substrate) | | Insulating layer | | | Circuit layer | | B value | Von Mises stress simulation value (Pa) |
|---|---|---|---|---|---|---|---|---|---|
| | Thickness ($\mu$m) | Elastic modulus at 100°C (GPa) | Thickness ($\mu$m) | Elastic modulus at 100°C (GPa) | Thickness/Elastic modulus ($\mu$m/Gpa) | Thickness ($\mu$m) | Elastic modulus at 100°C (GPa) | | |
| Present Invention Example 38 | 1800 | | 110 | 8 | 14 | 35 | 125 | 2.44E + 08 | 2.49E + 08 |
| Present Invention Example 39 | 2000 | | 30 | 0.27 | 110 | 35 | 125 | 2.16E + 08 | 2.58E + 08 |
| Present Invention Example 40 | 2000 | | 110 | 8.0 | 14 | 35 | 75 | 2.36E + 08 | 2.39E + 08 |
| Present Invention Example 41 | 2000 | | 110 | 8 | 14 | 35 | 100 | 2.36E + 08 | 2.41E + 08 |
| Present Invention Example 42 | 2000 | | 110 | 8 | 14 | 35 | 125 | 2.36E + 08 | 2.42E + 08 |
| Present Invention Example 43 | 2000 | | 30 | 0.27 | 110 | 35 | 125 | 1.86E + 08 | 1.91E + 08 |

The correlation between the combined data of the A value and the B value and the von Mises stress simulation value was evaluated by the least squares method. As a result, the correlation coefficient between the combined data of the A value and the B value and the von Mises stress simulation value was 0.95. From the above-described result, it was confirmed that von Mises stress that is applied to solder when an electronic component is mounted via the solder on a metal base substrate in which a copper substrate is used can be highly accurately predicted using the formula (I) or formula (II).

[Present Invention Example 46 and Comparative Examples 1 and 5]

Metal base substrates were produced in the same manner as in Present Invention Example 1 except that an aluminum substrate (composition: Alloy No.A4032, Al-Si system) was used instead of the copper substrate and the thickness of the aluminum substrate, the thickness and elastic modulus at 100°C of the insulating layer, and the thickness and elastic modulus at 100°C of the circuit layer were each changed to values shown in Table 3 and Table 4 below. The elastic modulus of the insulating layer was adjusted by changing the amount of a filler packed and the type of a resin that was used as a matrix.

[Evaluation]

(Calculation of C value or D value)

For metal base substrates of Present Invention Examples 44 to 66 in which the thickness of the aluminum substrate was less than 1600 $\mu$m and the thickness and elastic modulus at 100°C of the insulating layer, and the thickness and elastic modulus at 100°C of the circuit layer were each the value shown in Table 3 below, C values were calculated using the formula (III). The results are shown in Table 3. In addition, for metal base substrates of Present Invention Examples 67 to 76 and Comparative Examples 1 to 9 in which the thickness of the aluminum substrate was 1600 $\mu$m or more and the thickness and elastic modulus at 100°C of the insulating layer, and the thickness and elastic modulus at 100°C of the circuit layer were each the value shown in Table 4 below, D values were calculated using the formula (IV). The results are shown in Table 4.

(Simulation value of von Mises stress)

Simulation values of von Mises stress that was applied to solder when electronic components were mounted via the solder on metal base substrates for which the aluminum substrates, the insulating layers, and the copper foils used in Present Invention Examples 44 to 76 and Comparative Examples 1 to 9 were used were calculated in the same manner as described above. The results are shown in Table 3 and Table 4.

[Table 3]

| | Metal substrate (aluminum substrate) | | Insulating layer | | | Circuit layer | | C value | Von Mises stress simulation value (Pa) |
|---|---|---|---|---|---|---|---|---|---|
| | Thickness ($\mu$m) | Elastic modulus at 100°C (GPa) | Thickness ($\mu$m) | Elastic modulus at 100°C (GPa) | Thickness/Elastic modulus ($\mu$m/Gpa) | Thickness ($\mu$m) | Elastic modulus at 100°C (GPa) | | |
| Present Invention Example 44 | 1000 | | 30 | 0.27 | 110 | 140 | 75 | 1.26E + 08 | 1.34E + 08 |
| Present Invention Example 45 | 1000 | | 30 | 0.27 | 110 | 140 | 100 | 1.12E + 08 | 1.32E + 08 |
| Present Invention Example 46 | 1000 | | 30 | 0.27 | 110 | 140 | 125 | 9.81E + 07 | 1.31E + 08 |
| Present Invention Example 47 | 1000 | | 110 | 2.0 | 55 | 140 | 75 | 1.32E + 08 | 1.39E + 08 |
| Present Invention Example 48 | 1000 | | 110 | 2.0 | 55 | 140 | 125 | 1.03E + 08 | 1.35E + 08 |
| Present Invention Example 49 | 1000 | | 110 | 4.0 | 28 | 140 | 75 | 1.36E + 08 | 1.42E + 08 |
| Present Invention Example 50 | 1000 | | 110 | 4.0 | 28 | 140 | 125 | 1.07E + 08 | 1.36E + 08 |

(continued)

| | Metal substrate (aluminum substrate) | | Insulating layer | | | Circuit layer | | C value | Von Mises stress simulation value (Pa) |
|---|---|---|---|---|---|---|---|---|---|
| | Thickness ($\mu$m) | Elastic modulus at 100°C (GPa) | Thickness ($\mu$m) | Elastic modulus at 100°C (GPa) | Thickness/Elastic modulus ($\mu$m/Gpa) | Thickness ($\mu$m) | Elastic modulus at 100°C (GPa) | | |
| Present Invention Example 51 | 1000 | | 110 | 8.0 | 14 | 140 | 75 | 1.41E + 08 | 1.41E + 08 |
| Present Invention Example 52 | 1000 | | 110 | 8.0 | 14 | 140 | 125 | 1.11E + 08 | 135E + 08 |
| Present Invention Example 53 | 1400 | | 30 | 0.27 | 110 | 140 | 75 | 2.43E + 08 | 230E + 08 |
| Present Invention Example 54 | 1400 | | 30 | 0.27 | 110 | 140 | 125 | 2.13E + 08 | 2.20E + 08 |
| Present Invention Example 55 | 1400 | 72 | 110 | 8.0 | 14 | 140 | 75 | 2.64E + 08 | 2.69E + 08 |
| Present Invention Example 56 | 1400 | | 110 | 8.0 | 14 | 140 | 125 | 2.32E + 08 | 2.49E + 08 |
| Present Invention Example 57 | 1000 | | 30 | 0.27 | 110 | 35 | 75 | 1.58E + 08 | 1.53E + 08 |

(continued)

| | Metal substrate (aluminum substrate) | | Insulating layer | | | Circuit layer | | C value | Von Mises stress simulation value (Pa) |
|---|---|---|---|---|---|---|---|---|---|
| | Thickness (μm) | Elastic modulus at 100°C (GPa) | Thickness (μm) | Elastic modulus at 100°C (GPa) | Thickness/Elastic modulus (μm/Gpa) | Thickness (μm) | Elastic modulus at 100°C (GPa) | | |
| Present Invention Example 58 | 1000 | | 30 | 0.27 | 110 | 35 | 100 | 1.55E + 08 | 1.67E + 08 |
| Present Invention Example 59 | 1000 | | 30 | 0.27 | 110 | 35 | 125 | 1.51R + 08 | 1.79E + 08 |
| Present Invention Example 60 | 1000 | | 110 | 2.0 | 55 | 35 | 75 | 164E + 08 | 1.53E + 08 |
| Present Invention Example 61 | 1000 | | 110 | 2.0 | 55 | 35 | 125 | 1.57E + 08 | 1.79E + 08 |
| Present Invention Example 62 | 1000 | | 110 | 4.0 | 28 | 35 | 75 | 1.69E + 08 | 1.57E + 08 |
| Present Invention Example 63 | 1000 | | 110 | 4.0 | 28 | 35 | 125 | 1.62E + 08 | 1.70E + 08 |
| Present Invention Example 64 | 1000 | | 110 | 8.0 | 14 | 35 | 75 | 1.74E + 08 | 1.58E + 08 |

| | Metal substrate (aluminum substrate) | | Insulating layer | | | Circuit layer | | C value | Von Mises stress simulation value (Pa) |
|---|---|---|---|---|---|---|---|---|---|
| | Thickness ($\mu$m) | Elastic modulus at 100°C (GPa) | Thickness ($\mu$m) | Elastic modulus at 100°C (GPa) | Thickness/Elastic modulus ($\mu$m/Gpa) | Thickness ($\mu$m) | Elastic modulus at 100°C (GPa) | | |
| Present Invention Example 65 | 1000 | | 110 | 8.0 | 14 | 35 | 125 | 1.67E + 08 | 1.57E + 08 |
| Present Invention Example 66 | 1400 | | 30 | 0.27 | 110 | 35 | 75 | 2.77E + 08 | 2.94E + 08 |

[Table 4]

| | Metal substrate (aluminum substrate) | | Insulating layer | | | Circuit layer | | D value | Von Mises stress simulation value (Pa) |
|---|---|---|---|---|---|---|---|---|---|
| | Thickness (μm) | Elastic modulus at 100°C (GPa) | Thickness (μm) | Elastic modulus at 100°C (GPa) | Thickness/Elastic modulus (μm/Gpa) | Thickness (μm) | Elastic modulus at 100°C (GPa) | | |
| Present Invention Example 67 | 1600 | | 30 | 0.27 | 110 | 140 | 75 | 3.00E + 08 | 2.48E + 08 |
| Present Invention Example 68 | 1600 | | 110 | 8.0 | 14 | 140 | 125 | 2.92E + 08 | 2.75L + 08 |
| Present Invention Example 69 | 1800 | | 110 | 8.0 | 14 | 140 | 125 | 2.84E + 08 | 2.83E + 08 |
| Present Invention Example 70 | 2000 | | 110 | 8.0 | 14 | 140 | 100 | 2.92E + 08 | 2.90E + 08 |
| Present Invention Example 71 | 2000 | | 110 | 8.0 | 14 | 140 | 125 | 2.76E + 08 | 2.81E + 08 |
| Present Invention Example 72 | 2000 | | 30 | 0.27 | 110 | 140 | 75 | 2.78E + 08 | 2.45E + 08 |
| Present Invention Example 73 | 2000 | | 30 | 0.27 | 110 | 140 | 100 | 2.62E + 08 | 2.39E + 08 |
| Present Invention Example 74 | 2000 | 72 | 30 | 0.27 | 110 | 140 | 125 | 2.46E + 08 | 2.34E + 08 |
| Present Invention Example 75 | 2000 | | 110 | 8.0 | 14 | 140 | 75 | 3.09E + 08 | 3.00E + 08 |

(continued)

| | Metal substrate (aluminum substrate) | | Insulating layer | | | Circuit layer | | D value | Von Mises stress simulation value (Pa) |
| --- | --- | --- | --- | --- | --- | --- | --- | --- | --- |
| | Thickness (μm) | Elastic modulus at 100°C (GPa) | Thickness (μm) | Elastic modulus at 100°C (GPa) | Thickness/Elastic modulus (μm/Gpa) | Thickness (μm) | Elastic modulus at 100°C (GPa) | | |
| Present Invention Example 76 | 2000 | | 30 | 0.27 | 110 | 35 | 125 | 3.06E+08 | 3.64E+08 |
| Comparative Example 1 | 1600 | | 110 | 8.0 | 14 | 140 | 75 | 3.24E+08 | 2.97E+08 |
| Comparative Example 2 | 1600 | | 30 | 0.27 | 110 | 35 | 75 | 3.34E+08 | 3.18E+08 |
| Comparative Example 3 | 1600 | | 30 | 0.27 | 110 | 35 | 125 | 3.27E+08 | 3.74E+08 |
| Comparative Example 4 | 1600 | | 110 | 8.0 | 14 | 35 | 75 | 3.60E+08 | 3.24E+08 |
| Comparative Example 5 | 1600 | | 110 | 8.0 | 14 | 35 | 125 | 3.52E+08 | 3.74E+08 |
| Comparative Example 6 | 1800 | | 110 | 8.0 | 14 | 35 | 125 | 3.45E+08 | 3.78E+08 |
| Comparative Example 7 | 2000 | | 110 | 8.0 | 14 | 35 | 75 | 3.46E+08 | 3.20L+08 |
| Comparative Example 8 | 2000 | | 110 | 8.0 | 14 | 35 | 100 | 3.42E+08 | 3.35E+08 |
| Comparative Example 9 | 2000 | | 110 | 8.0 | 14 | 35 | 125 | 338E+08 | 3.68E+08 |

**EP 4 131 362 A1**

The correlation between the combined data of the C value and the D value and the von Mises stress simulation value was evaluated by the least squares method. As a result, the correlation coefficient between the combined data of the C value and the D value and the von Mises stress simulation value was 0.93. From the above-described result, it was confirmed that von Mises stress that is applied to solder when an electronic component is mounted via the solder on a metal base substrate in which an aluminum substrate is used can be highly accurately predicted using the formula (III) or formula (IV).

(Reliability against thermal cycles)

For the metal base substrates produced in Present Invention Examples 1, 10, 15, 16, 22, 27, and 46 and Comparative Examples 1 and 5, the reliability against thermal cycles was measured by the following method. The results are shown in Table 5 below.

Sn-Ag-Cu solder was applied onto the copper foil of the metal base substrate to form a solder layer having a length of 2.5 cm, a width of 2.5 cm, and a thickness of 100 $\mu$m, and a 2.5 cm $\times$ 2.5 cm Si chip was mounted on the solder layer, thereby producing a test body. 3000 cycles of thermal cycles in which 1 cycle was made up of -40°C for 30 minutes and 150°C for 30 minutes were applied to the produced test body. The test body after the application of the thermal cycles was embedded in a resin, a cross section was observed using a sample from which the cross section was exposed by polishing, and the length (mm) of a crack initiated in the solder layer was measured. A value calculated from the length of one side of the solder layer and the measured length of the crack by the following formula was regarded as the bonding reliability.

$$\text{Reliability (\%)} = \{(\text{length of one side of solder layer (25 mm) - } 2 \times \text{length of}$$

$$\text{crack})/\text{length of one side of bonding layer (25 mm)}\} \times 100$$

[Table 5]

|  | A value to D value | von Mises stress simulation value (Pa) | Reliability against thermal cycles (%) |
|---|---|---|---|
| Present Invention Example 1 | 1.24E + 08 | 1.27E + 08 | 99 |
| Present Invention Example 10 | 2.01E + 08 | 1.98E + 08 | 89 |
| Present Invention Example 15 | 2.53E + 08 | 2.45E + 08 | 83 |
| Present Invention Example 16 | 1.20E + 08 | 1.30E + 08 | 98 |
| Present Invention Example 22 | 1.30E + 08 | 1.29E + 08 | 97 |
| Present Invention Example 27 | 2.48E + 08 | 2.39E + 08 | 79 |
| Present Invention Example 46 | 9.81E + 07 | 1.31E + 08 | 95 |
| Comparative Example 1 | 3.24E + 08 | 2.97E + 08 | 71 |
| Comparative Example 5 | 3.52E + 08 | 3.74E + 08 | 48 |

It was confirmed that, for all of Present Invention Examples 1, 10, 15, 16, 22, 27, and 46 in which any of the A value to the D value was in a range of $0.50 \times 10^8$ or more and $3.10 \times 10^8$ or less, the reliability against thermal cycles was high. This is because the elastic modulus (unit: GPa) at 100°C of the insulating layer, the elastic modulus (unit: GPa) at 100°C of the circuit layer, the thickness (unit: $\mu$m) of the insulating layer, the thickness (unit: $\mu$m) of the circuit layer, and the thickness (unit: $\mu$m) of the metal substrate in the metal base substrate are set so as to satisfy predetermined formulae and thus stress that is applied from the metal base substrate to solder due to thermal cycles is reduced.

On the other hand, in Comparative Examples 1 and 5 in which the D value exceeded $3.10 \times 10^8$, the reliability against thermal cycles deteriorated. This is because stress that is applied from the metal base substrate to solder due to thermal cycles becomes large.

[Reference Signs List]

1S Bonded structure
10, 10S Metal base substrate
20, 20S Metal substrate
30, 30S Insulating layer
31 Insulating resin
32 Inorganic filler
40 Circuit layer
40S Copper foil
50, 50S Solder
60, 60S Electronic component
61, 61S Electrode terminal
62S AlN (aluminum nitride) member

**Claims**

1. A metal base substrate comprising:

a metal substrate;
an insulating layer; and
a circuit layer, which are laminated in this order,
wherein the insulating layer contains an insulating resin and an inorganic filler,
in a case where the metal substrate is a copper substrate having a thickness of less than 1600 $\mu$m, A that is defined by the following formula (I) is in a range of $0.50 \times 10^8$ or more and $3.10 \times 10^8$ or less,
in a case where the metal substrate is a copper substrate having a thickness of 1600 $\mu$m or more, B that is defined by the following formula (II) is in a range of $0.50 \times 10^8$ or more and $3.10 \times 10^8$ or less,
in a case where the metal substrate is an aluminum substrate having a thickness of less than 1600 $\mu$m, C that is defined by the following formula (III) is in a range of $0.50 \times 10^8$ or more and $3.10 \times 10^8$ or less, and
in a case where the metal substrate is an aluminum substrate having a thickness of 1600 $\mu$m or more, D that is defined by the following formula (IV) is in a range of $0.50 \times 10^8$ or more and $3.10 \times 10^8$ or less,

$$A = \left\{ (0.56 \times t_3)^{0.9} + \left\{ \frac{0.001 \times k_2 \times t_2 \times \log\left(\frac{t_1}{k_1}\right)}{\log t_3} \right\} - 0.03 \times t_3 \times \left(\frac{t_1}{k_1}\right)^{0.12} \right\}$$

$$\times\, 921000 - 107800000$$

$$\cdots \ (\mathrm{I})$$

$$B = \left\{ (896)^{0.9} + \left\{ \frac{0.001 \times k_2 \times t_2 \times \log\left(\frac{t_1}{k_1}\right)}{\log t_3} \right\} - 0.03 \times t_3 \times \left(\frac{t_1}{k_1}\right)^{0.12} \right\}$$

$$\times\, 921000 - 107800000$$

$$\cdots \ (\mathrm{II})$$

$$C =$$

$$\left\{ (0.99 \times t_3)^{0.9} + \left\{ \frac{0.0009 \times k_2 \times t_2 \times \log\left(\frac{t_1}{k_1}\right)}{\log t_3} \right\} - 0.026 \times t_3 \times \left(\frac{t_1}{k_1}\right)^{0.19} - 0.0019 \times (\log t_3) \times k_2 \times t_2 \right\}$$

$$\times\, 792980 - 174800000$$

$$\cdots \quad (\text{III})$$

$$D =$$

$$\left\{ (1584)^{0.9} + \left\{ \frac{0.0009 \times k_2 \times t_2 \times \log\left(\frac{t_1}{k_1}\right)}{\log t_3} \right\} - 0.026 \times t_3 \times \left(\frac{t_1}{k_1}\right)^{0.19} - 0.0019 \times (\log t_3) \times k_2 \times t_2 \right\}$$

$$\times\, 792980 - 174800000$$

$$\cdots \quad (\text{IV})$$

in the formula (I) to the formula (IV), $k_1$ represents an elastic modulus (unit: GPa) at 100°C of the insulating layer, $k_2$ represents an elastic modulus (unit: GPa) at 100°C of the circuit layer, $t_1$ represents a thickness (unit: $\mu$m) of the insulating layer, $t_2$ represents a thickness (unit: $\mu$m) of the circuit layer, and $t_3$ represents a thickness (unit: $\mu$m) of the metal substrate.

2. The metal base substrate according to claim 1,
   wherein the insulating layer has a ratio of the thickness (unit: $\mu$m) to the elastic modulus (unit: GPa) at 100°C of 10 or more.

FIG. 1

FIG. 2

FIG. 3

## INTERNATIONAL SEARCH REPORT

International application No.

PCT/JP2021/013892

### A. CLASSIFICATION OF SUBJECT MATTER

H01L 23/14(2006.01)i; H05K 1/05(2006.01)i
FI: H05K1/05 B; H05K1/05 A; H01L23/14 M

According to International Patent Classification (IPC) or to both national classification and IPC

### B. FIELDS SEARCHED

Minimum documentation searched (classification system followed by classification symbols)
H01L23/14; H05K1/05

Documentation searched other than minimum documentation to the extent that such documents are included in the fields searched

| | |
|---|---|
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2015-43417 A (DAINIPPON PRINTING CO., LTD.) 05 March 2015 (2015-03-05) paragraphs [0088]-[0089], [0167] | 1-2 |
| Y | WO 2004/064467 A1 (FUJITSU LTD.) 29 July 2004 (2004-07-29) specification, page 14, line 29 to page 15, line 22 | 1-2 |
| Y | JP 2010-287844 A (MITSUBISHI ELECTRIC CORP.) 24 December 2010 (2010-12-24) paragraphs [0032]-[0038], table 3 | 1-2 |
| Y | JP 2008-218596 A (DENKI KAGAKU KOGYO KABUSHIKI KAISHA) 18 September 2008 (2008-09-18) paragraphs [0025]-[0033], table 1 | 1-2 |
| Y | JP 2005-353974 A (HITACHI CHEMICAL INDUSTRY CO., LTD.) 22 December 2005 (2005-12-22) paragraphs [0012], [0022], [0024] | 1-2 |

☐ Further documents are listed in the continuation of Box C.  ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 June 2021 (14.06.2021) | 22 June 2021 (22.06.2021) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

| International application No. |
| --- |
| PCT/JP2021/013892 |

| Patent Documents referred in the Report | Publication Date | Patent Family | Publication Date |
| --- | --- | --- | --- |
| JP 2015-43417 A | 05 Mar. 2015 | (Family: none) | |
| WO 2004/064467 A1 | 29 Jul. 2004 | US 2005/0218503 A1 paragraphs [0066]-[0067] TW 200414860 A CN 1714608 A | |
| JP 2010-287844 A | 24 Dec. 2010 | (Family: none) | |
| JP 2008-218596 A | 18 Sep. 2008 | (Family: none) | |
| JP 2005-353974 A | 22 Dec. 2005 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020065162 A
- JP H1187866 A
- JP 2016111171 A